(19) Europäisches Patentamt
European Patent Office
Office européen des brevets

(11) Publication number: **0 136 130 B1**

(12) **EUROPEAN PATENT SPECIFICATION**

(45) Date of publication of patent specification: **06.12.89**

(51) Int. Cl.$^4$: **G 03 F 7/26**

(21) Application number: **84306149.0**

(22) Date of filing: **07.09.84**

(54) **Method of making articles using gas functionalized plasma developed layer.**

(30) Priority: **16.09.83 US 532776**

(43) Date of publication of application:
**03.04.85 Bulletin 85/14**

(45) Publication of the grant of the patent:
**06.12.89 Bulletin 89/49**

(84) Designated Contracting States:
**BE DE FR GB IT NL SE**

(56) References cited:
**EP-A-0 058 214**

**EXTENDED ABSTRACTS, vol. 82-2, October 1982, pages 321-322, abstract no. 201, Pennington, N.J., US; D. FOLLETT et al.: "Polarity reversal of PMMA by treatment with chlorosilanes"**

**PATENTS ABSTRACTS OF JAPAN, vol. 6, no. 88 (P-118)966r, 26th May 1982; & JP - A - 57 23 937**

(73) Proprietor: **AMERICAN TELEPHONE AND TELEGRAPH COMPANY**
**550 Madison Avenue**
**New York, NY 10022 (US)**

(72) Inventor: **Stillwagon, Larry Edward**
**73 Beechwood Road**
**Summit New Jersey 06901 (US)**
Inventor: **Taylor, Gary Newton**
**236 Windmill Court**
**Bridgewater New Jersey 08807 (US)**
Inventor: **Venkatesan, Thirumalai Nallan Chakravarthy**
**254 Windmill Court**
**Bridgewater New Jersey 08807 (US)**
Inventor: **Wolf, Thomas Michael**
**52 Unneberg Avenue**
**Succasunna New Jersey 07876 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 136 130 B1

(56) References cited:

PATENTS ABSTRACTS OF JAPAN, vol. 2, no. 6, 17th January 1978, page 9918 E 78; & JP - A - 53 122 427

CHEMICAL ABSTRACTS, vol. 98, no. 4, January 1983, page 557, no. 25448p, Columbus, Ohio, US; F. MARTINET et al.: "Plasma treatment for resin hardening" & VIDE, COUCHES MINCES 1982, 212(Suppl.), 361-9

JOURNAL OF THE ELECTROCHEMICAL SOCIETY, vol. 131, no. 7, July 1984, pages 1664-1670, Manchester, New Hampshire, US; T.M. WOLF et al.: "The scope and mechanism of new positive tone gas-phase-functionalized plasma-developed resists"

JOURNAL OF THE ELECTROCHEMICAL SOCIETY, vol. 131, no. 7, July 1984, pages 1658-1664, Manchester, New Hampshire, US; G.N. TAYLOR: "Gas-phase-functionalized plasma-developed resists: initial concepts and results for electron-beam exposure"

**Description**

The present invention concerns a method of making articles by the use of an organic layer, developed by a plasma atmosphere, for pattern delineation.

In the production of solid-state devices, including, for example, semiconductor devices, magnetic bubble devices, optical waveguide devices, it is necessary to form patterns having very small dimensions on a substrate or other device precursor. In addition, lithographic shadow masks are likewise patterned to define device geometries. Lithographic resists are typically used that are patterned by radiation and developed. The developed pattern may thereafter be transferred to an underlying layer by a variety of techniques, including plasma etching, ion milling, ion implantation, wet chemistry. The patterning radiation has included a variety of types, including electron beams, ultraviolet light, and visible light. Other sources are also being explored, including X-ray radiation and ion beams. In the past, the development of the irradiated resist has frequently been by dissolution of the irradiated or unirradiated regions of the resist by means of a development solution. This produced either a positive tone image or a negative tone image, respectively, depending upon the resist chemistry and developer type. Recently, a trend has occurred away from liquid developers, especially in very fine line lithography. Dry development has been accomplished by exposure of the resist to a plasma; see, for example, U.S. Patent No. 4,232,110.

It has been found by one of the present inventors that by including an organometallic monomer in a polymeric resist, protective regions can be formed in irradiated regions of a resist upon plasma etching. For example, protective oxide regions can be formed in an oxygen plasma that etches the unprotected regions; see U.S. Patent No. 4,396,704. Both silicon and nonsilicon organometallic monomers have been found useful. Another recent lithography technique has been developed by two of the present inventors, whereby ions, for example metallic ions, are selectively implanted in a material. The implanted ions react with a plasma, typically oxygen, to form a compound that protects the implanted region upon subsequent plasma etching: see U.S. Patent No. 4,377,437.

Not only must a resist technology provide for the generation of fine lines, but in many cases it must also accommodate step coverage over previously formed features on a device precursor, while still maintaining the geometry of the pattern as it is transferred from the resist into the device precursor. Maintaining fine lines usually requires relatively thin resists, whereas providing good step coverage usually requires relatively thick resists. To accommodate these conflicting requirements, multilevel resists have been invented. In the multilevel technique, a relatively thick resist is initially applied to a device precursor to provide for good step coverage and provide a relatively planar surface, with a thin resist being deposited thereon. A pattern is then generated in the thin resist and transferred to the underlying layer by reactive ion etching or other techniques. It is also frequently advantageous to interpose a hard metallic or oxide layer between the two resist levels; see, for example, U.S. Patent No. 4,244,799. For a recent review of multilevel resist technology, see "Multilayer Resist Systems and Processing," B. J. Lin, *Solid-State Technology,* pages 105—112, May 1983.

In Extended Abstracts, vol. 82-2 (1982) pages 321—322 there is described a method as set out in the preamble to claim 1. In this method reverse polarity is achieved using a poly(methyl methacrylate) resist (PMMA). A PMMA layer is selectively irradiated with an electron beam, which forms a latent pattern. Then the layer is treated with dichlorodimethylsilane gas, which preferentially permeates the irradiated portions of the layer. When treated with water vapour the absorbed gas is hydrolysed to form polysiloxane which interpenetrates with the PMMA. This interpenetrating network is comparatively highly resistant to plasma etching thus the latent pattern can be developed to leave resist at the irradiated regions whilst removing it from the unirradiated regions.

EP—A—0058214 describes a method in which portions of a chromium layer which are exposed through apertures in a resist mask are treated with a plasma to form a $C_rF_2$ surface layer which is resistant to a chromium etch solution applied subsequently.

Patent Abstracts of Japan, vol. 6, No. 88 (P-118) (1966) describes a method in which a resist layer is treated with hexamethyl-disilazine which reacts with it prior to irradiation.

According to the present invention there is provided a method as set out in claim 1 hereof.

In the drawings:

Fig. 1 shows an embodiment of the present invention;

Fig. 2 shows an embodiment of the present invention wherein the patterning lithographic radiation is substantially absorbed in a near-surface layer of the organic layer, whereby a negative tone image is obtained.

Fig. 3 shows functionalization with the aid of $H_2O$ as a reactant;

Fig. 4 shows a dual layer technique embodying the invention whereby an inorganic-containing gas MR is sorbed into unirradiated regions of the top layer to produce a positive tone image in the top and bottom layers upon reactive ion etching of the bottom layer;

Fig. 5 shows a dual layer technique embodying the invention whereby an inorganic-containing gas is sorbed into the bottom layer to obtain a negative tone image in the bottom layer upon etching starting from a positive tone top layer;

Fig. 6 shows a dual layer technique embodying the invention whereby a negative tone top layer is used to form either a negative or positive tone image in a bottom layer;

Fig. 7 shows a diagram of a system suitable for performing gas functionalization; and

Fig. 8 shows a gas cell suitable for accomplishing gas functionalization.

The following detailed description relates to a technique for forming lithographic images, wherein an inorganic-containing gas is sorbed into an organic layer, typically a polymeric resist film. An inorganic species derived from the sorbed gas forms a protective compound in the organic layer that protects the organic layer or an underlying layer, or both, during exposure to a plasma etching atmosphere. The protective compound may also include a species derived from the plasma.

The term "functionalize" and its derivatives mean that the sorbed gas chemically reacts or complexes with either a constituent of the organic layer, or with an external agent such as water vapor in the ambient above the layer, or both.

In one embodiment, the functionalization occurs selectively either in an irradiated or unirradiated region of the organic layer. The irradiation of the organic layer can occur before, during, or after the gas sorption, depending on the radiation type and chemistry involved. The sorbed gas that remains unreacted is typically then desorbed, by evacuation, heating, etc. The organic layer is developed by exposure to a plasma, whereby unprotected portions of the organic layer are removed, thereby producing a desired pattern in the organic layer.

In a second embodiment, the desired lithographic pattern is initially formed in the organic layer by conventional techniques, as by liquid development or conventional plasma development of a selectively irradiated resist. The developed resist is then functionalized with the inorganic-containing gas. The protective compound formed in the resist then serves to selectively protect an underlying layer, which may be organic or inorganic, from a plasma etching atmosphere. In this manner, the pattern formed in the resist is transferred to the underlying layer.

The inorganic species of the sorbed gas can be a metal or other element capable of forming a relatively nonvolatile protective compound. Suitable elements include those conventionally considered to be metallic elements by organic chemists in the formation of organometallic compounds. In addition to true metals, such elements include silicon, germanium, boron, etc. The inorganic species should be capable of forming a protective compound that resists the plasma that etches the unprotected regions of the desired layer to be etched. For this purpose, a protective compound having a vaporization (boiling) point of at least 300 degrees C, and preferably at least 500 degrees C, is desirable. The term "plasma," as used herein, means an atmosphere having at least one ionized species in an amount effective to assist the etching of the unprotected portions of the desired layer, and the term includes reactive ion etching, among other techniques. The term "resist" is also used illustratively herein when referring to an organic layer. However, the organic layer need not perform as a resist on a device precursor, but can be used itself in a device, as for optical diffraction gratings, waveguides, etc.

Since the functionalizing step is a gas-solid reaction, surface layers of the resist react first if the reaction rate constant is equal to, or greater than, the diffusion rate constant, or if the major portion of the incident radiation is absorbed in the topmost (approximately 100—200 nanometers) layer of resist. For the first case, a reactive gas diffusing into a polymer film, the concentration *c* of a gaseous species at a depth *x* (in μm) into a film from the film surface can be estimated by Equation (1) where $C_0$ is the continuous gas concentration at the surface, D is the diffusion coefficient in $cm^2\ sec^{-1}\times10^6$, and *t* is the diffusion time in seconds.

$$C=C_0\ \mathrm{erfc}\frac{x}{2\sqrt{Dt}} \qquad (1)$$

This is the simplified plane sheet solution to the one-dimensional diffusion problem.

For the present purposes, it is analytically convenient to calculate $C/C_0$ as a function of the variables *x*, D, and *t*. Some results are given in Table 1 for two polymers of interest. In all cases, both inert ($C_2$, Ar) and interactive ($SF_6$) gases diffuse more readily into rubbery poly(isoprene) PI than into glassy poly(ethyl methacrylate) PEM. In fact, for PI, after treatment for 1 second, the gas concentration is expected to be higher in a 1 μm film than in the gas phase for each gas listed. Only for PEM and large molecule gases (Ar, $SF_6$) are $C/C_0$ values less than 1.0 found. With $SF_6$, a significant interaction with the PEM ester carbonyl is expected. Consequently, D is very low and no gas penetrates even 1 μm deep for treatment times as long as 10 seconds. At shallower depths, a gradient of $SF_6$ is expected. Reaction in the near-surface top 200 nm region is clearly favored by short treatment times and low diffusion coefficients associated with large gas molecules and glassy polymers.

The glass transition temperature ($T_g$) of a polymer and the processing temperature determine the state of the polymer. Hence, a polymer can be processed in the rubbery state by performing the sorption, desorption, or functionalization steps at a temperature above $T_g$. This allows, for example, faster diffusion of the gas into the polymer. Conversely, processing below $T_g$ helps provide for a near-surface functionalization. As used herein, the term "near-surface" means effective sorption to less than one-half the thickness of a layer whose pattern is determined by actinic lithographic irradiation applied thereto. In the case of an underlying layer of a multilevel resist, the term "near-surface" means effective sorption to a thickness less than one-tenth the minimum linewidth desired. The state of the polymer can be shifted by changing the temperature during processing. For example, gas sorption and functionalization below $T_g$ can

result in a well-defined near-surface pattern, whereas increasing the temperature above $T_g$ can provide for rapid desorption to allow faster processing; other temperature sequences are possible. Fig. 1 presents a representation of the foregoing near-surface functionalization. The lithographic radiation is shown as substantially penetrating the thickness of the resist, producing P therethrough. However, a lithographic radiation that penetrates only partially into the resist can also be used. Both positive tone and negative tone images can be obtained.

TABLE 1
Dependence of $C/C_0$ on polymer and gas diffusion properties and on processing properties at 25°C

| Gas | D $\frac{cm^2 \times 10^6}{sec}$ | t (sec) | x (μm) | $C/C_0$ |
|---|---|---|---|---|
| A. Poly(isoprene), $T_g$=73°C | | | | |
| $O_2$ | 1.73 | 1.0 | 1.0 | 1.45 |
| Ar | 1.36 | 1.0 | 1.0 | 1.0 |
| $SF_6$ | 0.115 | 1.0 | 1.0 | 1.03 |
| B. Poly(ethyl methacrylate), $T_g$=65°C | | | | |
| $O_2$ | 0.103 | 1.0 | 1.0 | 1.00 |
| Ar | 0.020 | 1.0 | 1.0 | 0.65 |
| $SF_6$ | 0.00022 | 1.0 | 1.0 | 0.00 |
| $SF_6$ | 0.00022 | 1.0 | 0.5 | 0.00 |
| $SF_6$ | 0.00022 | 1.0 | 0.1 | 0.67 |
| $SF_6$ | 0.00022 | 10.0 | 1.0 | 0.00 |
| $SF_6$ | 0.00022 | 10.0 | 0.5 | 0.44 |
| $SF_6$ | 0.00022 | 10.0 | 0.25 | 0.77 |
| $SF_6$ | 0.00022 | 10.0 | 0.1 | 1.15 |

An alternative to diffusion-controlled reactions in the near-surface region is irradiation of the resist selectively in the near-surface region, followed by gas functionalization, desorption of unreacted MR, and RIE development as above. This is represented schematically in Fig. 2 for the negative tone case. In the case of diffusion of inorganic reagent MR throughout the film, only the negative tone can be achieved in theory. Selective functionalization of original species A to obtain positive tone formation in this instance results in reaction of subsurface layers as well, thus preventing development of positive tone patterns. The consequence is at best only relief image formation upon development, rather than complete development. In the case of restricted gas permeation to the near-surface regions, positive tone can be formed, with advantages being derived from the near-surface irradiation.

Near-surface irradiation can be achieved most readily with ion beam lithography and photolithography. Use of low energy (approximately 20—50 keV), high atomic number (Z) ions permits irradiation of only the top 10 to 250 nm of a typical organic resist because of the very rapid stopping of the ionic species. For UV and visible photons, resists containing 10 weight percent of compounds having $\varepsilon \geq 40,000$ l/mole-cm at the radiation wavelength absorb ≥90 percent of the incident light in the topmost 250 nm and ≥40 percent in the first 100 nm. In the vacuum UV ($\lambda < 190$ nm), many polymers have $\varepsilon_{values} > 10^5$ l/mole-cm, while highly conjugated aromatic materials have similar absorbences in 190—700 nm region. Materials which meet the high absorbence criteria are, therefore, readily available for ion or photon irradiation. In the photon case, improved resolution can result, whereas for ions, sensitivity can be enhanced by the use of the near-surface irradiation embodiment.

In electron lithography, large benefits can be realized by the present technique. These result because the proximity effect, which distorts pattern size as a function of geometry in the 1 μm to 0.1 μm range, can be reduced. The present resist scheme, as embodied in Fig. 1, can achieve this, since only the near-surface portion of the organic layer in this embodiment is selectively functionalized by the inorganic species, thus reducing the contributions to exposure by electrons backscattered from the substrate.

Usually an oxygen plasma is employed in the development step because most inorganic oxides act as excellent in situ masks (i.e., have low etch rates), and inorganic-free organic materials have relatively high etch rates. However, freon, halocarbon ($CCl_4$, $CHBr_3$), or even reducing ($H_2$) plasmas, among others, can be used if the corresponding inorganic compound formed therewith is nonvolatile. For example, many metals are likely to make good masks for $H_2$ plasma development. Their effeciencies are limited primarily by the metal atom sputter yields and ease of conversion to volatile hydrides. An analysis of the Group IV elements is illustrative. In Table 2 we list the boiling points of hydrides, oxides, and halides for these elements. Only Pb appears suitable for hydrogen plasma etching if conversion to the hydride by the plasma were efficient. Oxygen etching is useful for Si, Ge, Sn, and Pb, while Pb is a good mask in any oxygen-free halocarbon plasma. Tin is expected to be a good mask in fluorine and iodine plasmas.

TABLE 2

Boiling points for group IV hydrides, oxides, and halides[e] in °C

| Element | Hydride | Oxide | Fluoride | Chloride | Bromide | Iodide |
|---|---|---|---|---|---|---|
| C | −164 | −78.5[d] | −128 | 77 | 189 | 171[b] |
| Si | −112 | 2230 | −86 | 57 | 154 | 287 |
| Ge | −88 | 1115 | −37[a] | 84 | 187 | 240[a, c] |
| Sn | −52 | 1850[a] | 750[a] | 114 | 202 | 717 |
| Pb | [b] | >890[b] | 1290[c] | 950[c] | 916[c] | 954 |

a. Sublimes
b. Decomposes
c. Divalent halide
d. Dioxide
e. Data from *CRC Handbook of Chemistry and Physics,* R. C. Weart, Ed., The Chemical Rubber Company, Cleveland, 1969.

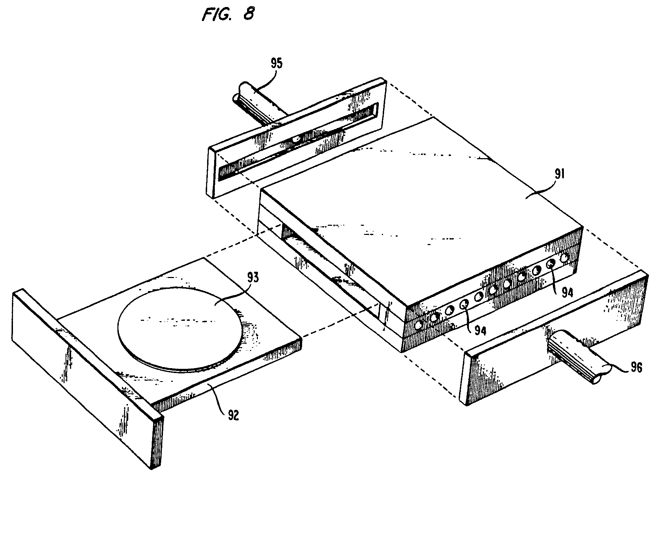

The above technique is more fully illustrated in the Examples below, using the functionalization apparatus outlined in Fig. 7. Gas functionalization was conducted in a reaction cell; see Fig. 8. It comprises a stainless steel chamber 91 with a Teflon (trademark of E. I. Dupont) drawer 92 for insertion of a resist-coated wafer 93. Purging gases, carrier gases, and reactive inorganic-containing gases entered and exited the cell through a series of port 94 on the sides of the reactor. The cell volume of 250 ml limited the equilibration time. Nevertheless, fast equilibration times, on the order of a few seconds, resulted.

The inorganic-containing gas (typically an inorganic halide) entered the reactor in a stream of dry carrier gas (either nitrogen or argon). A three-necked 250 ml flask was charged with approximately 50 ml of a suitable liquid inorganic halide such as $SnCl_4$, $SiCl_4$, or $Me_2SiCl_2$. The flask was equipped with a fritted gas inlet tube positioned below the surface of the inorganic halide. A second neck served as an exit to the reactor and was connected with a 0.635 cm stainless steel glass-metal seal. Nitrogen bubbling through the inorganic halide entrained small amounts of inorganic halide. (In an alternate arrangement, a single necked flask connected directly to the gas cell was used). Likewise, the system was connected to a reservoir containing drying agents such as hexamethyldisilazane or thionyl chloride. These drying agents removed trapped and residual surface water in the reactor by continuous reaction and purging. The gaseous products were removed by the carrier gas. Analogously, water (and other reagents) were introduced by the incorporation of a water entrainment system.

Typically, a resist-coated wafer was processed as follows: A portion of an irradiated wafer, or an entire 7.62 cm wafer, was placed in the reactor. The reactor typically was evacuated for 1 minute to a pressure of 13.33 Pa (0.1 Torr). After isolating the reactor from the vacuum pump, the inorganic halide reservoir was opened to the reactor through inlet 95. The $N_2$/MX mixture was allowed to pressurize the reactor to a pressure of 13,790—20,684 Pa (2—3 psi) (2 seconds). The outlet 96 was then opened, and the $N_2$/MX mixture was allowed to pass over the surface of the wafer for 1—120 seconds. Then the carrier gas was turned off. The reactor was evacuated for 5 minutes to remove all traces of gaseous MX. The functionalized resist-coated wafer was then removed and subjected to oxygen reactive ion etching. Etching was done in a Cooke Vacuum Products Reactive Ion Etcher using oxygen as the sole etchant. The typical etching conditions were 20 W, 1.33—2.67 Pa (10—20 mTorr) $O_2$, and an oxygen flow of 8—12 sccm.

Example I

A silicon wafer was coated with Selectilux N-60 resist by spin-coating to give a 1 μm thick film. This resist comprises an azide as a sensitizer. The spun film was baked at 80 degrees C for 15 minutes in a forced air oven and irradiated for 16 seconds on a Cobilt Model CA2020H contact printer utilizing ultraviolet

radiation having wavelengths predominately near 366 nanometers. The wafer was placed in a gas reaction cell which was evacuated for 2 minutes to a pressure of at least 13.33 Pa (0.1 Torr). Then silicon tetrachloride ($SiCl_4$), maintained at its saturated vapor pressure in a 1 liter ballast tank, was admitted to the reactor. After treatment for 7 seconds, the reactor was evacuated for 2—5 minutes to a pressure of at least 13.33 Pa (0.1 Torr), and the cell was filled to atmospheric pressure with dry inert gas ($N_2$ or Ar). The substrate was transferred to a reactive ion etching station and etched in $O_2$ as before for 6—7 minutes. This caused complete clearing of the irradiated regions and left 650—700 nm of film in the unirradiated regions. The resolution achieved was 0.6 µm lines and 1.4 µm spaces equivalent to the actual measured dimensions of the nominal 1.0 µm lines and spaces on the chrome mask. This Example illustrates the "positive tone" embodiment of Fig. 3. An analysis of the functionalized resist prior to plasma development showed that a significant amount of inorganic species also reacted in the irradiated region. Thus, instead of merely producing group "P" in the irradiated region, inorganic-containing groups "PMR" subsisted there, along with groups "AMR" in the unirradiated region, as before. However, the groups "AMR" were found to form complexes with the azide sensitizer, and these complexes were readily hydrolyzed upon exposure to water vapor in the ambient after the gas cell treatment. A protective oxide thus is formed in the unirradiated regions. In contrast, in the irradiated regions, the azide sensitizer was substantially converted to an amine compound during the irradiation process, forming an amino-inorganic compound upon exposure to the inorganic gas. This amino-inorganic compound (PMR) was not as protective as the AMR compound, resulting in the positive tone image of Fig. 3. In other experiments substantially similar to this Example, $SnCl_4$ and $(CH_3)_2SiCl_2$ were successfully used instead of $SiCl_4$ as the inorganic gas. These experiments and subsequent analysis show the utility of forming complexes during the functionalization step. A "complex" is a recognized type of chemical bonding typically weaker than covalent bonding, wherein electrons are shared among the groups forming the complex; see *Organic Charge-Transfer Complexes,* at page 2, R. Foster, Academic Press, New York (1969).

While the foregoing has illustrated the use of actinic radiation to form the desired pattern, it is also possible to use the present technique to define an underlying layer in a multilevel resist. In one embodiment, referring to Fig. 4, actinic radiation and subsequent development produce a positive tone image in the top layer of a bilevel resist. Gaseous inorganic functionalization selectively produces a protective layer in the remaining (unirradiated) regions of the top layer, but not in the bottom layer. It is possible for this top level to be a conventional wet-developed or plasma-developed resist, with the gaseous functionalization occurring after conventional development. Alternatively, the top level can also be developed by the present technique. In either case, after the gaseous inorganic treatment, the top layer includes an inorganic coating that protects it upon exposure to a plasma that develops the underlying layer. If the plasma is produced by a reactive ion etching apparatus, or other apparatus that imparts a degree of anisotropy to the development, then a relatively straight-walled relief image can be produced in the underlying layer. In an alternative embodiment of the multilevel technique, referring to Fig. 5, the top layer is patterned by actinic radiation and developed so as to produce a positive tone image. Then, the selective functionalization produces a protective layer in the uncovered underlying regions. The protective layer, upon plasma etching, then produces a negative tone image, wherein both the top layer and the unfunctionalized (unprotected) regions of the bottom layer are removed.

It is also possible to practice the multilevel technique utilizing a negative tone image in the top layer. Referring to Fig. 6, the negative resist pattern can be exposed and developed by a conventional technique; for example, a wet-developed photoresist. The resist is then exposed to an inorganic gas that selectively sorbs either into the negative resist pattern or the underlying layer. In the former case, the inorganic species protects the negative resist region upon subsequent plasma etching to produce a negative tone pattern, as indicated in Fig. 6. In the alternative embodiment of Fig. 6, wherein the inorganic gas sorbs only into the near-surface regions of the underlying resist region, the irradiated portion is removed, leaving a positive tone image.

The multilevel resist techniques will be more fully illustrated by means of the following Examples.

Example II

This Example illustrates the "tone retention" dual-layer embodiment shown in Fig. 6. A silicon wafer was spin-coated with HPR-204 positive photoresist (Philip A. Hunt Chemical Company) to give a 1.0 µm thick resist layer. The coated substrate was baked for 2 hours at 200 degrees C to give a hard-baked organic resist layer that was insoluble in organic solvents. This was spin-coated with Selectilux N-60 negative photoresist (E. M. Industries) to give a 600 nm layer after baking for 15 minutes at 80 degrees C. It was exposed to UV-visible light through a mask on a Cobilt contact printer for 2 seconds and was solution developed with N-60 developer to give 300 nm thick negative resist patterns with 1.5 µm line and space resolution. It was treated for 1 minute with $SiCl_4$ vapor (300 mm Hg pressure) in the above gas-phase reactor to selectively functionalize the topmost negative resist layer (as previously patterned). Then the areas not covered by negative resist were anisotropically etched for 7 minutes in a reactive ion etcher as above to remove $>1.0$ µm of the bottom hard-baked layer. No substantial loss of resist was observed in the remaining negative resist patterns. Resolution was 1.5 µm for lines and spaces and was limited by the resolution in the top resist layer. Negligible linewidth loss ($<0.1$ µm) was observed during the $O_2$ RIE transfer process.

Example III

In a manner analogous to Example II, Selectilux N-60 was used as both the top and bottom layers. Thus, a silicon wafer was spin-coated with Selectilux N-60 resist to give a 1.4 µm thick film. The coated substrate was hardened in a Ne plasma [100 W, 133.32 Pa (1.0 Torr)] for 15 minutes. Then the substrate was spin-coated with Selectilux N-60 to give a 600 nm thick film. After baking for 15 minutes at 80 degrees C, it was exposed for 4 seconds on a Cobilt contact printer as in Example IV. 350 nm thick negative tone patterns were obtained upon development using N-60 developer to give 1.25—1.50 µm resolution for lines and spaces. The sample was treated with $SiCl_4$ and subjected to $O_2$ RIE as in Example IV to give 1.25—1.50 µm line and space resolution, complete clearing of uncovered regions, and negligible thickness and linewidth (<0.1 µm) loss when etched for 13 minutes, and when overetched for an additional 5 minutes.

Example IV

In analogy to Example III, poly(glycidyl methacrylate-co-3-chlorostyrene) was spin-coated to a thickness of 1.2 µm on a silicon wafer and hardened in a Ne plasma. The use of a plasma for hardening is desirable to reduce gas sorption in the cleared portion of the underlying layer, which can lead to reduced resolution, and also to substantially eliminate intermixing between the top and bottom layers; see "Plasma Pretreatment to Improve Resist Properties by Reduction of Resist Flow During Postbake", J. M. Moran and G. N. Taylor, *Journal of Vacuum Science and Technology,* Vol. 19(4), pages 1127—1130 (1981). Then HPR-204 positive resist was spin-coated to a thickness of 800 nm on the hardened N-60 layer. After baking for 15—20 minutes at 80 degrees C, it was exposed for 25 seconds (carriage setting 177, aperture 4) with UV-visible light on a Perkin-Elmer Model 500 1:1 projection printer. Positive tone patterns having 1.0 µm resolution were obtained upon development using LSI aqueous alkaline developer. The resolution was limited by pattern quality on the mask. The substrate was treated for 2 minutes with 10 mm $TiCl_4$ in the above gas-phase reactor to selectively deposit Ti compounds on the positive tone topmost patterned resist. $O_2$ RIE, as in Examples IV and V, for 15 minutes completely cleared the uncovered bottom resist layer. Negligible resist thickness and linewidth losses (<0.1 µm) were observed during the transfer process, although the sample was overetched for nearly 3 minutes. Final resolution was 1.0 µm lines and spaces equivalent to the mask patterns.

In this last Example, it was found upon analysis that protective oxytitanium compounds were formed at least in part prior to the oxygen plasma treatment. We conclude that this is due in part to reaction with water vapor ($H_2O$) in the ambient above the resist after its removal from the functionalization cell, and in part due to reaction of $TiCl_4$ with $H_2O$ selectively sorbed in the positive resist layer. It thus is apparent that while the development plasma can assist in the protective layer formation, it need not do so in some cases. It is also possible that water vapor forms a lower valent oxide in some cases, with the plasma converting it to a higher valent oxide during development. It appears that the ambient environment in most semiconductor clean rooms, at about 30 to 40 percent relative humidity, is typically suitable for the hydrolyzing function. It is also possible to control the amount of water on the surface of the organic layer by exposure to a gas that reacts with water to produce gaseous products. For example, exposing the surface of cross-linked polystyrene to carbonyl fluoride has been found to reduce the amount of water on the surface.

The foregoing has shown the use of an inorganic compound to protect portions of the organic layer in which it is formed. However, we estimate that an inorganic compound formed from a sorbed gas can also be used to protect the organic layer during plasma etching of an underlying inorganic layer. For example, etching of aluminum or a silicide is typically accomplished using a plasma atmosphere comprising a halocarbon, and sometimes also oxygen. Such plasmas can attack the overlying resist, leading to loss of linewidth dimensions. Improved protection of the resist can be obtained by the use of an inorganic compound formed in the resist according to the present inventive technique. The resist can be an otherwise conventional resist developed by solution or plasma development, followed by the inorganic gas treatment. Alternatively. the resist can be developed according to the present technique. In that case, a first plasma can be used to develop the resist, and a second plasma used to etch the underlying inorganic layer. It is also possible that a single plasma type can be used for both purposes.

As noted above, the present technique can be used for making a wide variety of articles, including solid-state devices. As used herein, the term "device precursor" includes a semiconductor or insulator substrate, a magnetic substrate, an optical waveguide substrate, and a lithographic shadow mask substrate. It also includes a substrate having previously formed features, structures, or devices thereon. A wide variety of other metallic species can be used in the sorbed gas, as noted above.

**Claims**

1. A method of making an article including at least one pattern delineation step including providing a device precursor that includes at least one organic layer, sorbing a gas (MR) containing an inorganic species (M) into said layer, forming a protective compound (MY) comprising said inorganic species in at least a portion of said layer, and selectively removing by exposure to a plasma a portion of said device precursor, the portion of the device precursor that is selectively removed being a portion that is not protected by said protective compound, characterized by said gas being substantially sorbed only in a

surface or near-surface region of said organic layer, selectively irradiating said layer with actinic radiation before, during or after said sorbing of said gas, whereby the sorbed gas reacts with (a) the irradiated portions of said layer, or (b) the unirradiated portions of said layer, and thereafter substantially removing the unreacted gas from said organic layer, whereby said protective compound is formed in (a) the irradiated portions of said layer, or (b) in the unirradiated portions of said layer.

2. A method according to claim 1 characterized by selectively irradiating said layer with actinic radiation during or after said sorbing of said gas, whereby the inorganic species is removed from the irradiated portions of said organic layer, whereby said protective compound is formed in the unirradiated portions of said layer.

3. A method according to claim 1 characterized in that said organic layer is an underlying layer in a multilevel resist, wherein a pattern is formed in an overlying layer, and said sorbing a gas is accomplished in portions of said underlying organic layer where said overlying layer has been removed.

4. A method according to any of the preceding claims characterized in that said inorganic species is silicon, germanium, tin, lead, titanium or boron.

5. A method according to any of the preceding claims characterized in that said inorganic species is a true metal.

6. A method according to any of the preceding claims characterized in that said protective compound is formed at least in part by said exposure to a plasma, whereby said protective compound comprises at least one element (Y) derived from said plasma.

7. A method according to claim 6 characterized in that said plasma comprises oxygen, wherein an oxide of said inorganic species is formed as said protective compound.

8. A method according to any of the preceding claims characterized in that said organic layer comprises a group that reacts with said inorganic species to form complex that is thereafter hydrolyzed, thereby at least partially forming said protective compound.

9. A method according to claim 8, characterized in that said group is an azide or an inorganic halide.

10. A method according to any of the preceding claims characterized by exposing said organic layer to a gas that reacts with water to produce gaseous products, thereby controlling the amount of water on a surface of said organic layer.

11. A method according to claim 1 or 2, characterized in that said organic layer is an overlying layer in a multilevel resist.

12. A method according to claim 11, characterized in that said portion that is removed is from a region underlying said organic layer.

13. A method according to any of the preceding claims characterized in that said step of selectively irradiating the organic layer with actinic radiation includes subjecting said layer to ultraviolet radiation.

**Patentansprüche**

1. Verfahren zur Herstellung eines Gegenstandes mit wenigstens einem Musterabgrenzungsschritt, bei dem ein wenigstens eine organische Schicht enthaltender Bauteilvorläufer vorgesehen, ein ein organisches Material (M) enthaltendes Gas (MR) in der Schicht sorbiert, eine das organische Material enthaltende Schutzverbindung (MY) in wenigstens einem Teil der Schicht gebildet und selektiv ein Teil des Bauteilvorläufers durch Behandlung mit einem Plasma entfernt wird, wobei der selektiv entfernte Teil des Bauteilvorläufers ein Teil ist, der nicht durch die Schutzverbindung geschützt wird, dadurch gekennzeichnet,

daß das Gas im wesentlichen nur in einem Oberflächenbereich oder einem oberflächennahen Bereich der organischen Schicht sorbiert wird, daß die Schicht während oder nach dem Sorbieren des Gases selektiv mit einer aktinischen Strahlung bestrahlt wird, wodurch das sorbierte Gas (a) mit den bestrahlten Teilen oder (b) mit den nicht bestrahlten Teilen der Schicht reagiert, und daß danach das unreagierte Gas im wesentlichen aus der organischen Schicht entfernt wird, wodurch die Schutzverbindung in (a) den bestrahlten Teilen oder (b) den nicht bestrahlten Teilen der Schicht gebildet wird.

2. Verfahren nach Anspruch 1, dadurch gekennzeichnet, daß die Schicht während oder nach dem Sorbieren des Gases selektiv mit aktinischer Strahlung bestrahlt wird, wodurch das anorganische Material aus den bestrahlten Teilen der organischen Schicht entfernt und die Schutzverbindung in den nicht bestrahlten Teilen der Schicht gebildet wird.

3. Verfahren nach Anspruch 1, dadurch gekennzeichnet, daß die organische Schicht eine untere Schicht in einem mehrlagigen Resist ist, bei dem ein Muster in einer oberen Schicht gebildet wird und das Sorbieren eines Gases in Teilen der unteren organischen Schicht erfolgt, an denen die obere Schicht entfernt worden ist.

4. Verfahren nach einem der vorhergehenden Ansprüche, dadurch gekennzeichnet, daß das organische Material Silicium, Germanium, Zinn, Blei, Titan oder Bor ist.

5. Verfahren nach einem der vorhergehenden Ansprüche, dadurch gekennzeichnet, daß das anorganische Material ein echtes Metall ist.

6. Verfahren nach einem der vorhergehenden Ansprüche, dadurch gekennzeichnet, daß die Schutzverbindung wenigstens zum Teil durch Behandlung mit einem Plasma gebildet wird, wodurch die Schutzverbindung wenigstens ein aus dem Plasma gewonnenes Element (Y) enthält.

7. Verfahren nach Anspruch 6, dadurch gekennzeichnet, daß das Plasma Sauerstoff umfaßt, wodurch ein Oxid des anorganischen Materials als die Schutzverbindung gebildet wird.

8. Verfahren nach einem der vorhergehenden Ansprüche, dadurch gekennzeichnet, daß die organische Schicht eine Gruppe umfaßt, die mit dem anorganischen Material unter Bildung eines Komplexes reagiert, der anschließend hydrolisiert wird, wodurch wenigstens teilweise die Schutzverbindung gebildet wird.

9. Verfahren nach Anspruch 8, dadurch gekennzeichnet, daß die Gruppe ein Azid oder ein anorganisches Halogenid ist.

10. Verfahren nach einem der vorhergehenden Ansprüche, dadurch gekennzeichnet, daß die organische Schicht einem Gas ausgesetzt wird, das mit Wasser unter Bildung gasförmiger Produkte reagiert, wodurch die Menge an Wasser auf einer Oberfläche der organischen Schicht kontrolliert wird.

11. Verfahren nach Anspruch 1 oder 2, dadurch gekennzeichnet, daß die organische Schicht eine obere Schicht in einem mehrlagigen Resist ist.

12. Verfahren nach Anspruch 11, dadurch gekennzeichnet, daß der entfernte Teil aus einem Bereich unter der organischen Schicht stammt.

13. Verfahren nach einem der vorhergehenden Ansprüche, dadurch gekennzeichnet, daß der Schritt der selektiven Bestrahlung der organischen Schicht mit aktinischer Strahlung beinhaltet, daß die Schicht ultravioletter Strahlung ausgesetzt wird.

**Revendications**

1. Un procédé de fabrication d'un article comprenant au moins une étape de définition de motif, dans laquelle on fournit un précurseur de dispositif qui comprend au moins une couche organique, on provoque la sorption dans cette couche d'un gaz (MR) qui contient une substance inorganique (M), on forme un composé protecteur (MY), comprenant la substance inorganique, dans au moins une partie de la couche, et on enlève sélectivement, par exposition à un plasma, une partie du précurseur de dispositif, la partie du précurseur de dispositif qui est enlevée sélectivement étant une partie qui n'est pas protégée par le composé protecteur, caractérisé en ce que le gaz précité est pratiquement sorbé uniquement dans une région de surface ou de quasi-surface de la couche organique, on irradie sélectivement cette couche avec un rayonnement actinique avant, pendant ou après la sorption du gaz, grâce à quoi le gaz sorbé réagit avec (a) les parties irradiées de la couche, ou (b) les parties non irradiées de la couche, et on élimine ensuite pratiquement de la couche organique le gaz qui n'a pas réagi, grâce à quoi le composé protecteur est formé (a) dans les parties irradiées de la couche, ou (b) dans les parties non irradiées de la couche.

2. Un procédé selon la revendication 1, caractérisé en ce qu'on irradie sélectivement la couche avec un rayonnement actinique pendant ou après la sorption du gaz, grâce à quoi la substance inorganique est éliminée des parties irradiées de la couche organique, ce qui fait que le composé protecteur est formé dans les parties non irradiées de la couche.

3. Un procédé selon la revendication 1, caractérisé en ce que la couche organique est une couche sous-jacente dans une matière de réserve multicouche, dans laquelle un motif est formé dans une couche supérieure, et la sorption d'un gaz est effectuée dans des parties de la couche organique sous-jacente sur lesquelles la couche supérieure a été enlevée.

4. Un procédé selon l'une quelconque des revendications précédentes, caractérisé en ce que la substance inorganique est le silicium, le germanium, l'étain, le plomb, le titane ou le bore.

5. Un procédé selon l'une quelconque des revendications précédentes, caractérisé en ce que la substance inorganique est un métal proprement dit.

6. Un procédé selon l'une quelconque des revendications précédentes, caractérisé en ce que le composé protecteur est formé au moins en partie par l'exposition à un plasma, grâce à quoi ce composé protecteur comprend au moins un élément (Y) qui provient du plasma.

7. Un procédé selon la revendication 6, caractérisé en ce que le plasma comprend de l'oxygène, et un oxyde de la substance inorganique est formé à titre de composé protecteur.

8. Un procédé selon l'une quelconque des revendications précédentes, caractérisé en ce que la couche organique comprend un groupe qui réagit avec la substance inorganique pour former un complexe qui est ensuite hydrolysé, pour former au moins partiellement le composé protecteur.

9. Un procédé selon la revendication 8, caractérisé en ce que le groupe précité est un azide ou un halogénure inorganique.

10. Un procédé selon l'une quelconque des revendications précédentes, caractérisé en ce qu'on expose la couche organique à l'action d'un gaz qui réagit avec l'eau pour former des produits gazeux, de façon à définir ainsi la quantité d'eau sur une surface de la couche organique.

11. Un procédé selon la revendication 1 ou 2, caractérisé en ce que la couche organique est une couche supérieure dans une matière de réserve multicouche.

12. Un procédé selon la revendication 11, caractérisé en ce que la partie qui est enlevée provient d'une région qui se trouve au-dessous de la couche organique.

13. Un procédé selon l'une quelconque des revendications précédentes, caractérisé en ce que l'étape d'irradiation sélective de la couche organique avec un rayonnement actinique comprend l'exposition de la couche à un rayonnement ultraviolet.

FIG. 1

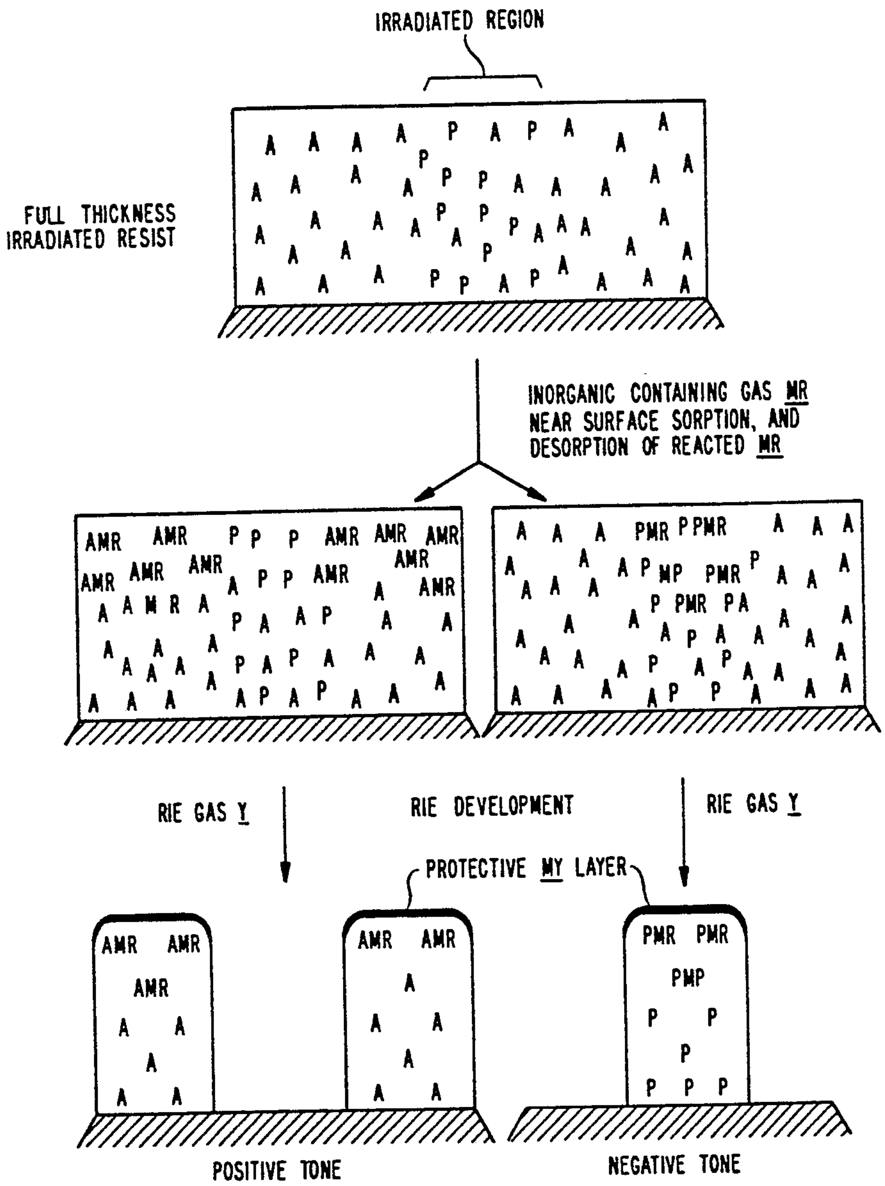
IRRADIATED REGION
FULL THICKNESS
IRRADIATED RESIST
INORGANIC CONTAINING GAS MR
NEAR SURFACE SORPTION, AND
DESORPTION OF REACTED MR
RIE GAS Y
RIE DEVELOPMENT
RIE GAS Y
PROTECTIVE MY LAYER
POSITIVE TONE
NEGATIVE TONE

FIG. 2

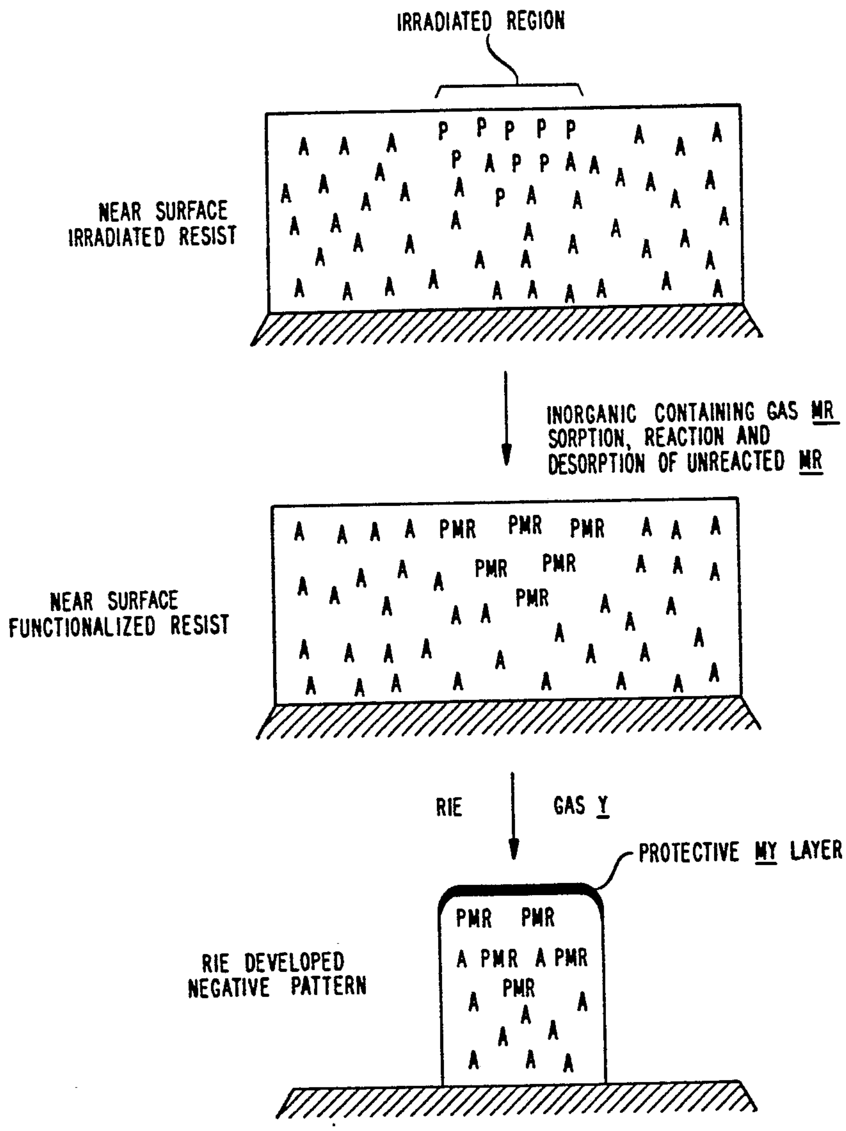
IRRADIATED REGION
NEAR SURFACE IRRADIATED RESIST
INORGANIC CONTAINING GAS MR
SORPTION, REACTION AND DESORPTION OF UNREACTED MR
NEAR SURFACE FUNCTIONALIZED RESIST
RIE
GAS Y
PROTECTIVE MY LAYER
RIE DEVELOPED NEGATIVE PATTERN

FIG. 3

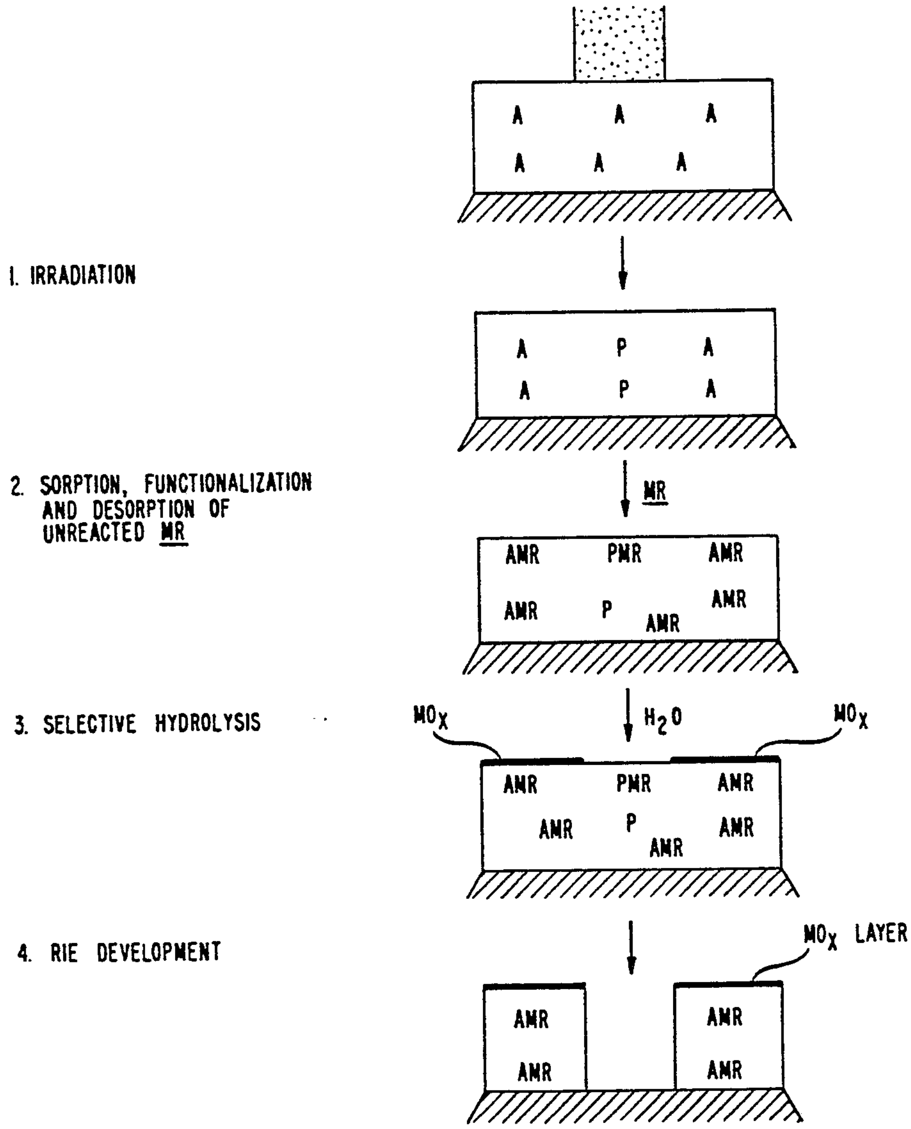
A A A
A A A
1. IRRADIATION
A P A
A P A
2. SORPTION, FUNCTIONALIZATION AND DESORPTION OF UNREACTED MR
MR
AMR PMR AMR
AMR P AMR AMR
3. SELECTIVE HYDROLYSIS
$MO_x$
$H_2O$
$MO_x$
AMR PMR AMR
AMR P AMR AMR
4. RIE DEVELOPMENT
$MO_x$ LAYER
AMR AMR
AMR AMR

FIG. 4

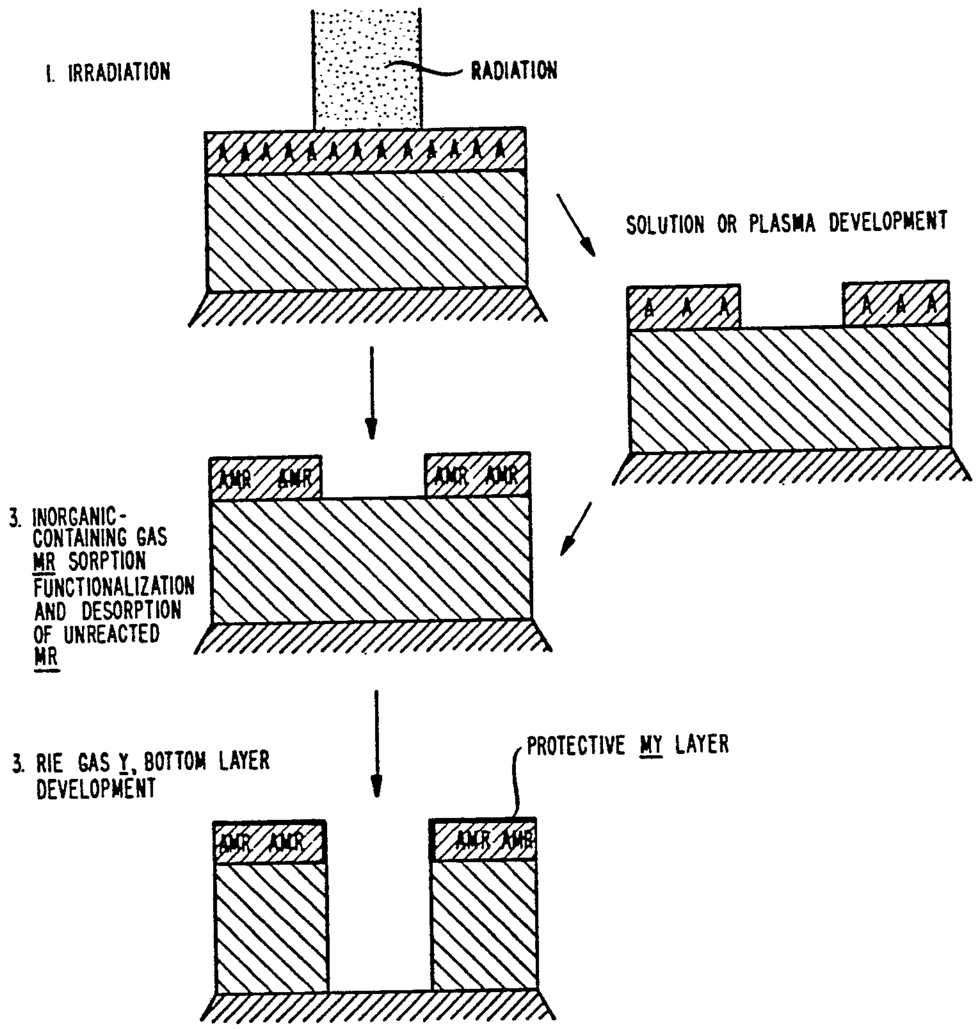
1. IRRADIATION
RADIATION
SOLUTION OR PLASMA DEVELOPMENT
3. INORGANIC-CONTAINING GAS MR SORPTION FUNCTIONALIZATION AND DESORPTION OF UNREACTED MR
AMR AMR
3. RIE GAS Y, BOTTOM LAYER DEVELOPMENT
PROTECTIVE MY LAYER

FIG. 5

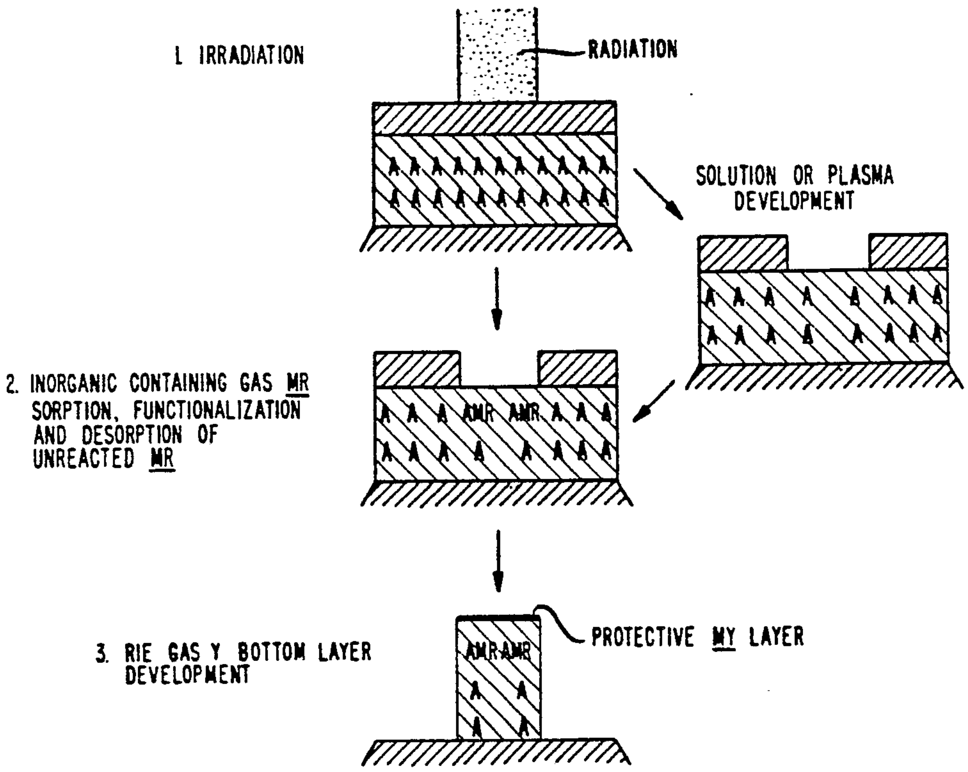
1. IRRADIATION
RADIATION
SOLUTION OR PLASMA DEVELOPMENT
2. INORGANIC CONTAINING GAS MR SORPTION, FUNCTIONALIZATION AND DESORPTION OF UNREACTED MR
AMR AMR
3. RIE GAS Y BOTTOM LAYER DEVELOPMENT
PROTECTIVE MY LAYER
AMRAMR

FIG. 7

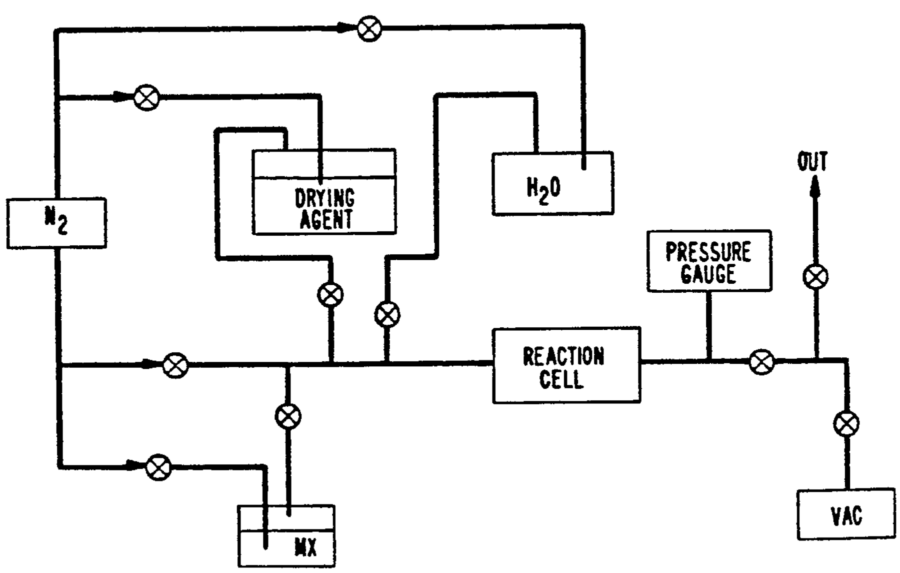
N2
DRYING AGENT
H2O
OUT
PRESSURE GAUGE
REACTION CELL
MX
VAC

*FIG. 6*

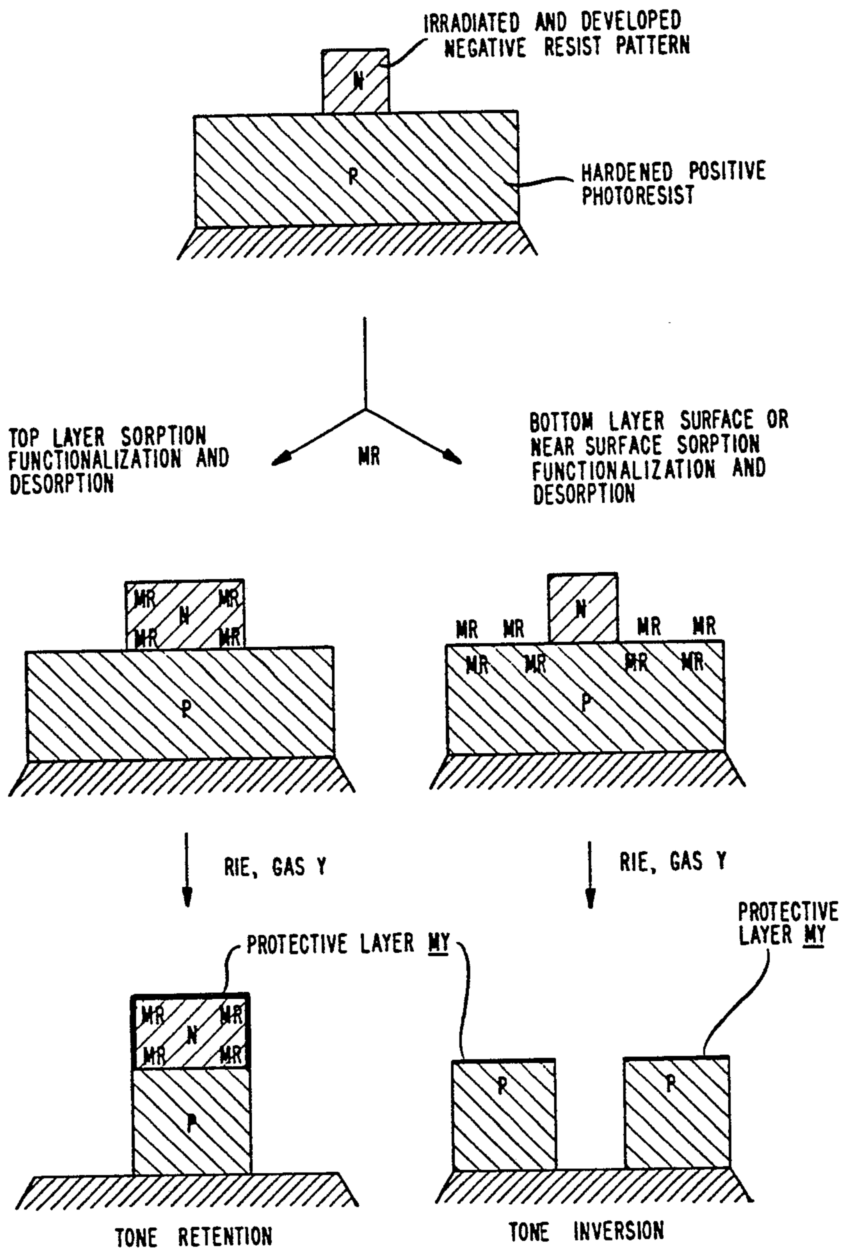
IRRADIATED AND DEVELOPED NEGATIVE RESIST PATTERN
N
P
HARDENED POSITIVE PHOTORESIST
TOP LAYER SORPTION FUNCTIONALIZATION AND DESORPTION
MR
BOTTOM LAYER SURFACE OR NEAR SURFACE SORPTION FUNCTIONALIZATION AND DESORPTION
RIE, GAS Y
RIE, GAS Y
PROTECTIVE LAYER MY
PROTECTIVE LAYER MY
TONE RETENTION
TONE INVERSION

*FIG. 8*